# EUROPEAN PATENT APPLICATION

(11) **EP 4 723 841 A1**
(43) Date of publication of application: **08.04.2026**
(21) Application number: 25176112.8
(22) Date of filing: 13.05.2025
(51) Int. Cl.: H10F 55/255, H10F 55/20, H10F 39/10, H10F 71/00, H10F 77/124

(54) **SEMICONDUCTOR STRUCTURE AND MANUFACTURING METHOD THEREOF**

(30) Priority: 07.10.2024 TW 113138047
(71) Applicant: Taiwan-Asia Semiconductor Corporation, Hsinchu City 30078 (TW)
(72) Inventor: WU, Hou-Jun, 30078 Hsinchu City (TW); SHAO, Chun-Sheng, 30078 Hsinchu City (TW)
(74) Representative: Michalski Hüttermann & Partner Patentanwälte mbB

(57) **Abstract**

A semiconductor structure and a manufacturing method thereof are provided. The semiconductor structure includes a bulk silicon substrate (100), an oxide layer (110), a patterned polycrystalline silicon layer (120) and a patterned epitaxial layer (130). The oxide layer is disposed above the bulk silicon substrate, the patterned polycrystalline silicon layer is disposed above the oxide layer, and the patterned epitaxial layer is disposed above the patterned polycrystalline silicon layer. The patterned epitaxial layer has an optoelectronic component (O) and a control circuit (C). The optoelectronic component and the control circuit are spatially isolated from each other due to the patterned polycrystalline silicon layer.

## Description

### CROSS-REFERENCES TO RELATED APPLICATIONS

This application claims the benefit of priority to Taiwanese Patent Application No. 113138047 filed on October 7, 2024, which is hereby incorporated by reference in its entirety.

### BACKGROUND OF THE INVENTION

### Field of the Invention

The present invention relates to a semiconductor structure and a manufacturing method thereof, and in particular to a semiconductor structure and a manufacturing method thereof for growing optoelectronic conversion elements on a bulk silicon substrate.

### Descriptions of the Related Art

Optoelectronic conversion elements are devices that use optical signals to control current or voltage and have widespread applications. Common optoelectronic conversion elements include, for example, photo voltage generation (PVG) devices, photo relays, optocouplers, photo-controlled transistors (PhotoMOS), and phototriacs. These elements share the characteristic of using optical signals for electrical signal isolation, control, or conversion, and are applied in electrical isolation, switching control, and circuit protection.

In manufacturing the aforementioned conventional optoelectronic conversion elements, SOI (Silicon On Insulator) wafers are often used instead of bulk silicon substrates to enhance device performance. The SOI wafer provides better electrical isolation characteristics through a thin silicon layer and an insulation layer on its surface for allowing the fabrication of optoelectronic components, transistors, and control circuits. However, the high cost of SOI wafers makes it difficult to achieve a cost-effective manufacturing process. Therefore, developing an innovative semiconductor structure that enables the production of optoelectronic components at a lower cost is a pressing issue.

### SUMMARY OF THE INVENTION

The primary objective of the present invention is to provide an innovative semiconductor structure and its manufacturing method to reduce the cost of manufacturing optoelectronic conversion elements while minimizing device size and improving reliability and performance.

To achieve the above objective, the present invention provides a semiconductor structure comprising a bulk silicon substrate, an oxide layer, a patterned polycrystalline silicon layer, and a patterned epitaxial layer. The oxide layer is disposed above the bulk silicon substrate, the patterned polycrystalline silicon layer is disposed above the oxide layer, and the patterned epitaxial layer is disposed above the patterned polycrystalline silicon layer. The patterned epitaxial layer includes an optoelectronic component and a control circuit, which are spatially isolated from each other corresponding to the patterned polycrystalline silicon layer.

In one embodiment of the semiconductor structure of the present invention, the oxide layer is a silicon dioxide layer.

In one embodiment of the semiconductor structure of the present invention, the optoelectronic component comprises a light-emitting diode or a photodiode.

In one embodiment of the semiconductor structure of the present invention, the control circuit comprises a transistor.

To achieve the above objective, the present invention provides a semiconductor structure comprising a bulk silicon substrate, a patterned oxide layer, a patterned polycrystalline silicon layer, a patterned epitaxial layer, and a control circuit. The patterned oxide layer is disposed above the bulk silicon substrate, the patterned polycrystalline silicon layer is disposed above the patterned oxide layer, and the patterned epitaxial layer is disposed above the patterned polycrystalline silicon layer, wherein the patterned epitaxial layer includes an optoelectronic component. The control circuit is disposed above an exposed portion of the bulk silicon substrate. The optoelectronic component and the control circuit are spatially isolated from each other corresponding to the patterned oxide layer.

To achieve the above objective, the present invention provides a manufacturing method of a semiconductor structure, comprising the steps of: providing a bulk silicon substrate; providing an oxide layer disposed above the bulk silicon substrate; providing a patterned polycrystalline silicon layer disposed above the oxide layer; and providing a patterned epitaxial layer disposed above the patterned polycrystalline silicon layer. The patterned epitaxial layer includes an optoelectronic component and a control circuit, which are spatially isolated from each other corresponding to the patterned polycrystalline silicon layer.

To achieve the above objective, the present invention provides a manufacturing method of a semiconductor structure, comprising the steps of: providing a bulk silicon substrate; providing a patterned oxide layer disposed above the bulk silicon substrate to expose a portion of the bulk silicon substrate; providing a patterned polycrystalline silicon layer disposed above the patterned oxide layer; providing a patterned epitaxial layer disposed above the patterned polycrystalline silicon layer, wherein the patterned epitaxial layer includes an optoelectronic component; and providing a control circuit disposed above the exposed portion of the bulk silicon substrate. The optoelectronic component and the control circuit are spatially isolated from each other corresponding to the patterned oxide layer.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 is a schematic diagram of a conventional optoelectronic conversion element manufactured using an SOI wafer;
FIG. 2 to FIG. 3 are schematic diagrams of a semiconductor structure manufacturing process according to an embodiment of the present invention;
FIG. 4 is a schematic diagram of applying the semiconductor structure of the present invention to a phototriac circuit;
FIG. 5 to FIG. 6 are schematic diagrams of another embodiment of the semiconductor structure manufacturing process according to the present invention;
FIG. 7 is a schematic diagram of applying the semiconductor structure of the present invention to a photo voltage generation device in a circuit;
FIG. 8 is a process flow diagram illustrating the manufacturing steps of a semiconductor structure in an embodiment of the present invention; and
FIG. 9 is a process flow diagram illustrating the manufacturing steps of another semiconductor structure in an embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

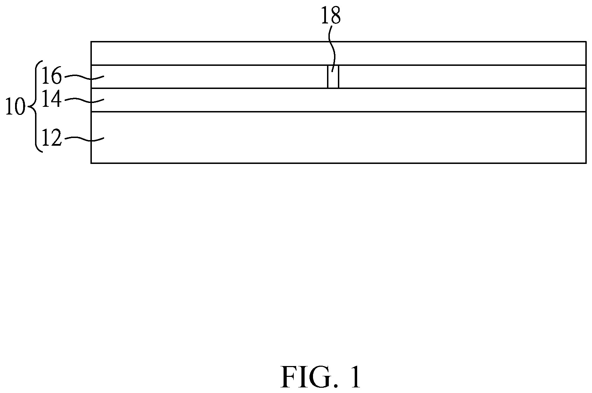

As mentioned earlier, to enhance device performance, conventional manufacturing of optoelectronic conversion components typically uses SOI wafers. However, the manufacturing process for SOI wafers is more complex than that of conventional bulk silicon wafers. It often requires additional steps such as placing a thin silicon layer over an insulating layer through techniques like ion implantation, high-precision cutting, and bonding. This makes the cost of SOI wafers several times higher than that of conventional bulk silicon wafers. Additionally, as shown in FIG. 1, the inventors found that when manufacturing optoelectronic conversion components using an SOI wafer, to simultaneously fabricate at least two different components (e.g., one is a light-emitting diode or a phototriac and the other is a transistor or a control circuit) on the same wafer, effective spatial and/or electrical isolation between these components is required to prevent mutual interference. The SOI wafer 10 must achieve effective isolation within the silicon thin film layer 16 above the insulating layer 14 on its silicon substrate 12 for forming an isolation region 18 between predetermined areas of each component. This isolation may be achieved by forming a trench isolation via wet etching or by ion implantation with an opposite polarity to the silicon thin film layer 16 to create a heavily doped region. Only after effective isolation is established in the silicon thin film layer 16 can the individual processing of different components in the optoelectronic conversion device proceed. Such complex pre-processing significantly increases manufacturing costs.

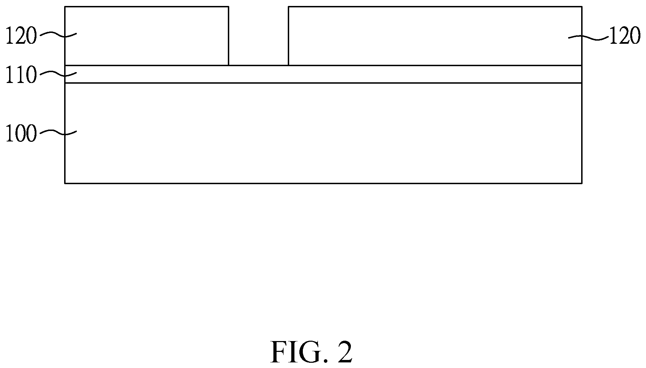

In view of this, the present invention discloses an innovative semiconductor structure that significantly reduces manufacturing costs while maintaining the performance of conventional optoelectronic conversion components. The invention will be described below with examples of a phototriac and a photo voltage generation (PVG) device. Those skilled in the art can naturally apply the invention to other optoelectronic conversion components, such as photo relays, photo couplers, and photo-controlled transistors (PhotoMOS), upon understanding the invention. Referring to FIG. 2, it illustrates a semiconductor structure and its manufacturing method in one embodiment of the present invention, particularly a semiconductor structure and a manufacturing method based on a bulk silicon substrate. First, a bulk silicon substrate 100 is provided. It should be noted that, to reduce manufacturing costs, the present invention does not use the aforementioned SOI wafers but instead employs a conventional bulk silicon wafer based on monocrystalline silicon as the growth substrate for the components. Next, an oxide layer 110 is formed on the bulk silicon substrate 100. In a specific embodiment, this oxide layer 110 is a silicon dioxide layer.

Secondly, since the optoelectronic conversion components involve epitaxial processes with certain III-V compound semiconductors (e.g., gallium arsenide, gallium nitride), which have lattice mismatch with silicon and significant differences in thermal expansion coefficients, leading to stress and defect dislocations, the present invention deposits a polycrystalline silicon layer 120 on the oxide layer 110 using techniques such as chemical vapor deposition (CVD). This layer serves to mitigate the lattice mismatch between III-V materials and the bulk silicon substrate 100 for reducing stress and defect formation. Due to its disordered structure, polycrystalline silicon can better accommodate lattice mismatches between different materials, facilitate transitions between different lattice orientations and reduce strain and defect density when III-V materials are directly grown on monocrystalline silicon. Thus, the quality of subsequent epitaxial growth will be improved.

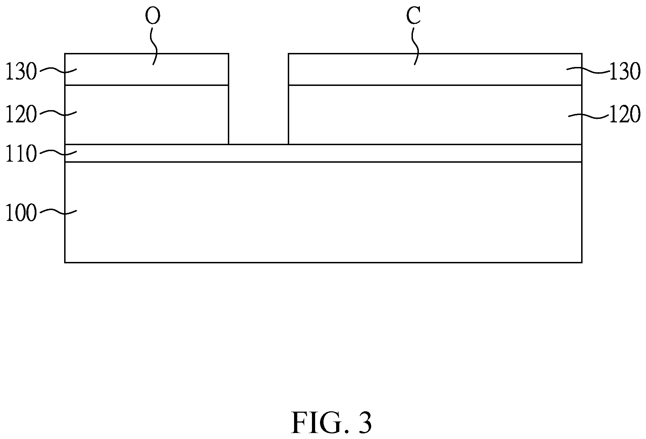

More specifically, to reduce the manufacturing cost and size of semiconductor devices, the present invention performs patterning on the polycrystalline silicon layer 120 based on the intended functionality and circuit arrangement of the device to form several spatially isolated patterned polycrystalline silicon layers on the oxide layer 110. This facilitates different processing steps on the polycrystalline silicon layer 120 in subsequent processes. As shown in FIG. 3, a patterned epitaxial layer 130 is formed above the patterned polycrystalline silicon layer 120 in response to its patterning. Specifically, for instance, an epitaxial process for III-V compound semiconductors (e.g., gallium arsenide, gallium nitride) can be performed on a portion of the patterned polycrystalline silicon layer, allowing selective epitaxial growth of the III-V compound semiconductor layer on that portion to form an optoelectronic component O, such as a light-emitting diode or a photodiode. On the other hand, a control circuit C, such as a transistor or other control components, is formed on other portions of the patterned epitaxial layer 130.

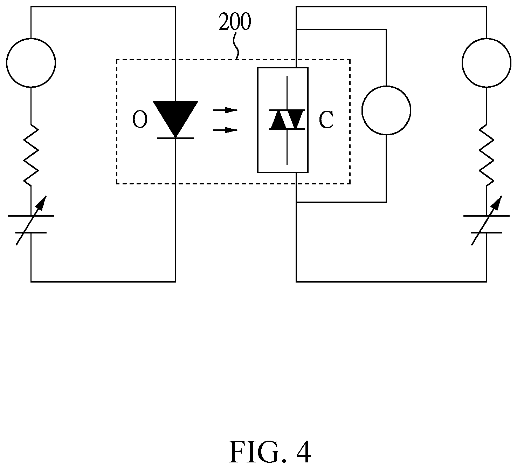

Obviously, as shown in FIG. 3, the optoelectronic component O and the control circuit C are spatially isolated from each other corresponding to the patterned polycrystalline silicon layer 120. This patterning process, combined with selective epitaxial growth, enables the fabrication of components with different functions on the same silicon wafer. This circuit integration reduces device size, lowers packaging costs, enhances device reliability, and mitigates interference between different components for thereby improving device performance. As shown in FIG. 4, the dashed area represents the application of the innovative semiconductor structure of the present invention in a phototriac 200, and a schematic diagram of its practical application in a circuit.

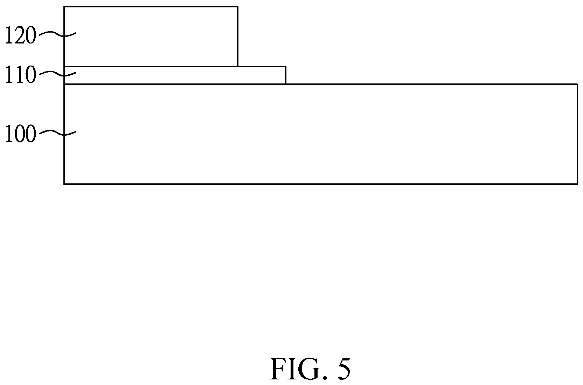

The following describes another embodiment of the present invention using a PVG device as an example. Unlike the previous embodiment, this embodiment is particularly suitable for components made of silicon-based materials in optoelectronic conversion devices, which do not require preprocessing for lattice adjustment and can be directly grown on a silicon wafer. Referring to FIG. 5, it shows a patterned oxide layer 110 formed on a bulk silicon substrate 100 in a specific predetermined region and a portion of the upper surface of the bulk silicon substrate 100 is exposed without being covered by the oxide layer 110. Next, a patterned polycrystalline silicon layer 120 is formed on this patterned oxide layer 110 to facilitate selective epitaxial growth in subsequent processes.

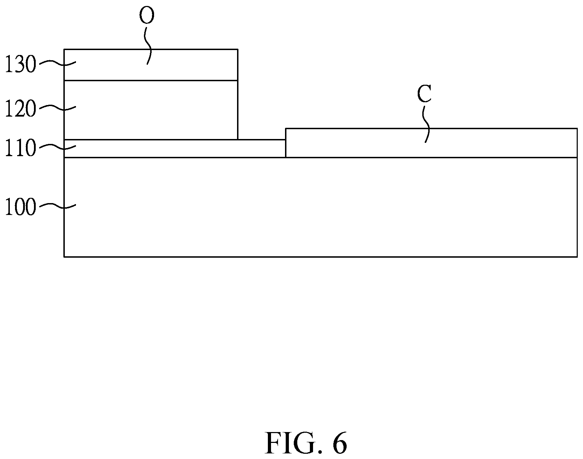

Referring to FIG. 6, as described earlier, the polycrystalline silicon layer 120 acts as a buffer for lattice adjustment for enabling selective epitaxial growth of a patterned epitaxial layer 130 on the patterned polycrystalline silicon layer 120. This allows the formation of an appropriate optoelectronic component O, such as a light-emitting diode or photodiode array (PDA), on the patterned epitaxial layer 130. On the other hand, a growth process suitable for silicon-based materials can be performed on the exposed portion of the bulk silicon substrate 100 to form functional components made of silicon-based materials, such as a transistor or other control components in a control circuit C, without requiring full-surface epitaxial growth of III-V materials across the entire wafer and thereby effectively reducing production costs.

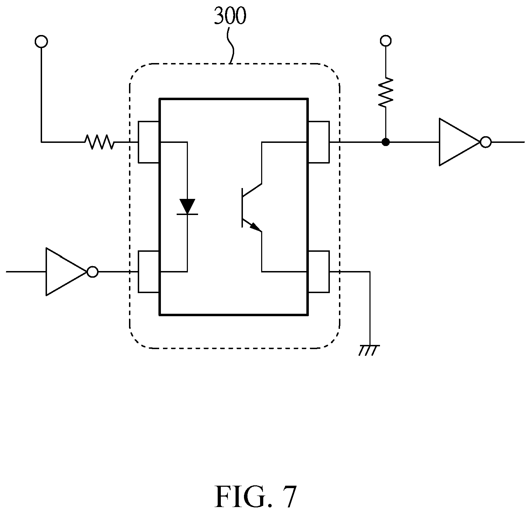

As shown in FIG. 6, the optoelectronic component O and the control circuit C are spatially isolated from each other corresponding to the patterned oxide layer 110 for achieving the goal of manufacturing components with different functions on the same silicon wafer. This helps reduce device size, lower packaging costs, mitigate interference between components, and enhance device performance. Referring to FIG. 7, the dashed area represents the application of the innovative semiconductor structure of the present invention in a photo voltage generation device 300, and a schematic diagram of its practical application in a circuit.

It should be noted that, in some embodiments, before forming the control circuit C, a portion of the patterned epitaxial layer may also be directly epitaxially grown on the exposed portion of the bulk silicon substrate 100 during the aforementioned selective epitaxial growth process. A control circuit C, including transistors or other control components, can then be directly formed on this portion of the patterned epitaxial layer. Since the control circuit C is typically made of silicon-based materials, lattice mismatch issues can be ignored during its growth process. Thus, even if the epitaxial layer grown directly on the exposed portion of the bulk silicon substrate 100 has more lattice defects or dislocations, it does not affect the functionality of the control circuit C. Therefore, in some embodiments, the control circuit C and the optoelectronic component O can be completed in the same epitaxial process.

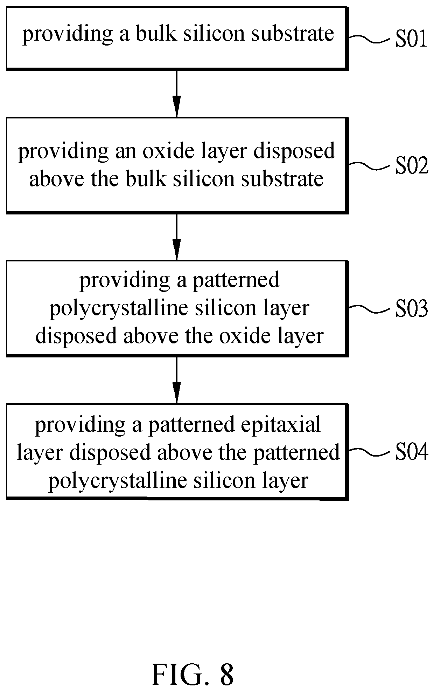

Referring to FIG. 8, it shows a schematic diagram of the process steps for a semiconductor structure in one embodiment of the present invention. First, in step S01, a bulk silicon substrate is provided. Next, in step S02, an oxide layer is provided and disposed above the bulk silicon substrate. In step S03, a patterned polycrystalline silicon layer is provided and disposed above the oxide layer. In step S04, a patterned epitaxial layer is provided and disposed above the patterned polycrystalline silicon layer. The patterned epitaxial layer includes an optoelectronic component and a control circuit, which are spatially isolated from each other corresponding to the patterned polycrystalline silicon layer. The composition and relationships of the components in each process step can be referred to the foregoing description and are not repeated here.

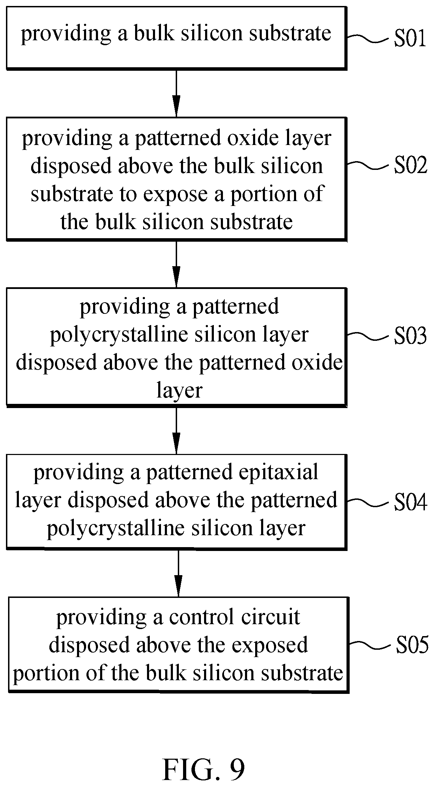

Referring to FIG. 9, it shows a schematic diagram of the process steps for a semiconductor structure in another embodiment of the present invention. First, in step S01, a bulk silicon substrate is provided. Next, in step S02, a patterned oxide layer is provided and disposed above the bulk silicon substrate to expose a portion of the bulk silicon substrate. In step S03, a patterned polycrystalline silicon layer is provided and disposed above the patterned oxide layer. In step S04, a patterned epitaxial layer is provided and disposed above the patterned polycrystalline silicon layer, wherein the patterned epitaxial layer includes an optoelectronic component. In step S05, a control circuit is provided and disposed above the exposed portion of the bulk silicon substrate, wherein the optoelectronic component and the control circuit are spatially isolated from each other corresponding to the patterned oxide layer. The composition and relationships of the components in each process step can be referred to the foregoing description and are not repeated here.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A semiconductor structure, comprising:
a bulk silicon substrate;
an oxide layer, disposed above the bulk silicon substrate;
a patterned polycrystalline silicon layer, disposed above the oxide layer; and
a patterned epitaxial layer, disposed above the patterned polycrystalline silicon layer,
wherein the patterned epitaxial layer has an optoelectronic component and a control circuit, the optoelectronic component and the control circuit are spatially isolated from each other corresponding to the patterned polycrystalline silicon layer.

2. The semiconductor structure of the previous claim, wherein the oxide layer is a silicon dioxide layer.

3. The semiconductor structure of any of the previous claims, wherein the optoelectronic component comprises a light-emitting diode or a photodiode.

4. The semiconductor structure of any of the previous claim, wherein the control circuit comprises a transistor.

5. A semiconductor structure, comprising:
a bulk silicon substrate;
a patterned oxide layer, disposed above the bulk silicon substrate to expose a portion of the bulk silicon substrate;
a patterned polycrystalline silicon layer, disposed above the patterned oxide layer;
a patterned epitaxial layer, disposed above the patterned polycrystalline silicon layer, wherein the patterned epitaxial layer has an optoelectronic component; and
a control circuit, disposed above the exposed portion of the bulk silicon substrate,
wherein the optoelectronic component and the control circuit are spatially isolated from each other corresponding to the patterned oxide layer.

6. The semiconductor structure of the previous claim, wherein the oxide layer is a silicon dioxide layer.

7. The semiconductor structure of any of the previous two claims, wherein the optoelectronic component comprises a light-emitting diode or a photodiode.

8. The semiconductor structure of any of the previous three claims, wherein the control circuit comprises a transistor.

9. A manufacturing method of a semiconductor structure, comprising:
providing a bulk silicon substrate;
providing an oxide layer, disposed above the bulk silicon substrate;
providing a patterned polycrystalline silicon layer, disposed above the oxide layer; and
providing a patterned epitaxial layer, disposed above the patterned polycrystalline silicon layer,
wherein the patterned epitaxial layer has an optoelectronic component and a control circuit, the optoelectronic component and the control circuit are spatially isolated from each other corresponding to the patterned polycrystalline silicon layer.

10. The manufacturing method of the previous claim, wherein providing the oxide layer is to provide a silicon dioxide layer.

11. A manufacturing method of a semiconductor structure, comprising:
providing a bulk silicon substrate;
providing a patterned oxide layer, disposed above the bulk silicon substrate to expose a portion of the bulk silicon substrate;
providing a patterned polycrystalline silicon layer, disposed above the patterned oxide layer;
providing a patterned epitaxial layer, disposed above the patterned polycrystalline silicon layer, wherein the patterned epitaxial layer has an optoelectronic component; and
providing a control circuit, disposed above the exposed portion of the bulk silicon substrate,
wherein the optoelectronic component and the control circuit are spatially isolated from each other corresponding to the patterned oxide layer.

12. The manufacturing method of the previous claim, wherein providing the patterned oxide layer comprises providing a patterned silicon dioxide layer.
